# EUROPÄISCHE PATENTSCHRIFT

(11) **EP 3 545 237 B1**
(45) Veröffentlichungstag und Bekanntmachung des Hinweises auf die Patenterteilung: **21.07.2021**
(21) Anmeldenummer: 17797949.9
(22) Anmeldetag: 15.11.2017
(51) Int. Cl.: F24C 7/08, D06F 34/28, A47L 15/42, H03K 17/96, D06F 34/32, D06F 105/58

(54) **HAUSHALTSGERÄT MIT ABNEHMBAREM HAPTISCHEM BEDIENELEMENT**
HOUSEHOLD APPLIANCE WITH REMOVABLE HAPTIC OPERATING ELEMENT
APPAREIL MÉNAGER AVEC ÉLÉMENT DE FONCTIONNEMENT HAPTIC AMOVIBLE

(30) Priorität: 25.11.2016 DE 102016223476
(43) Veröffentlichungstag der Anmeldung: 02.10.2019
(73) Patentinhaber: BSH Hausgeräte GmbH, 81739 München (DE)
(72) Erfinder: BELIVEAU, Thomas Eric, 80798 München (DE); SCHMIDT, Tobias, 81371 München (DE)
(86) Internationale Anmeldenummer: PCT/EP2017/079265
(87) Internationale Veröffentlichungsnummer: WO 2018/095773

(56) Entgegenhaltungen:
- WO-A1-2016/010231
- WO-A2-2008/003572
- DE-A1-102006 026 187
- DE-A1-102014 223 371
- US-A1- 2004 207 607

## Beschreibung

Die Erfindung betrifft ein Haushaltsgerät, wobei das Bedienelement des Haushaltsgerätes ein Anzeigefeld aufweist.

DE 10 2014 216 414 A1 offenbart eine Bedienvorrichtung für ein Haushaltsgerät, mit einem ersten Anzeigefeld und einem drehbaren Bedienelement, wobei das Anzeigefeld berührsensitiv ausgebildet ist und zumindest zwei verschiedene Funktionen des Haushaltsgeräts durch Berühren des Anzeigefelds an einem der jeweiligen Funktion zugehörigen Anzeigebereich auswählbar sind, wobei das Bedienelement einen Anzeigebereich aufweist, und wobei ein Anzeigen auf dem Anzeigebereich mit der über das Anzeigefeld ausgewählten Funktion gekoppelt ist und ein Parameter der ausgewählten Funktion durch Betätigen des Bedienelements veränderbar ist und ein dadurch eingestellter Parameterwert auf dem Anzeigebereich des Bedienelements angezeigt ist. DE 10 2014 216 414 A1 offenbart auch ein Haushaltsgerät. Hierbei ist es nachteilig, dass der Nutzer bei der Bedienung des Haushaltsgeräts immer noch häufig den Fokus seiner Aufmerksamkeit zwischen dem Drehknebel und dem Anzeigefeld wechseln muss.

Die DE 10 2014 223371 A1 offenbart alle Merkmale des Oberbegriffes des unabhängigen Anspruchs.

Die WO 2008/003572 A2 offenbart eine Übertragung einer Restwärmeanzeige von einem fest installierten Bildschirm auf ein abnehmbares Bedienelement.

Es ist die **Aufgabe** der vorliegenden Erfindung, die Nachteile des Standes der Technik zumindest teilweise zu überwinden und insbesondere eine Möglichkeit einer verbesserten Bedienbarkeit eines Haushaltsgeräts mit einem Anzeigefeld und einem haptischen Bedienelement bereitzustellen.

Diese Aufgabe wird gemäß den Merkmalen des unabhängigen Anspruchs gelöst. Bevorzugte Ausführungsformen sind insbesondere den abhängigen Ansprüchen entnehmbar.

Die Aufgabe wird gelöst durch ein Haushaltsgerät, dessen Bedienelement ein Anzeigefeld aufweist, wobei das Anzeigefeld zumindest teilweise als ein berührungsempfindlicher Bildschirm ausgebildet ist.

Dieses Bedienelement ergibt den Vorteil, dass ein Nutzer zur Bedienung des Haushaltsgeräts seine Aufmerksamkeit nicht mehr von dem haptischen Bedienelement wegzurichten braucht, um eine durch das haptische Bedienelement gewählte Einstellung zu betätigen oder zu aktivieren. Der Bildschirm ermöglicht dabei eine kontextbezogene Anzeige. Die Bestätigung oder Aktivierung wird durch eine Berührung des berührungsempfindlichen Teils (nämlich des berührungsempfindlichen Bildschirms) des Anzeigefelds erreicht. Insgesamt lässt sich so eine besonders klar strukturierte, fokussierte und kontextbezogene Gerätebedienung erreichen, was eine verbesserte Bedienbarkeit ergibt.

Unter einem haptischen Bedienelement kann insbesondere ein Bedienelement verstanden werden, das von einem Nutzer zu seiner Bedienung ergriffen werden kann. Das haptische Bedienelement kann eine Komponente des Haushaltsgeräts sein. Das Bedienelement kann dann als ein Haushaltsgeräte-Bedienelement angesehen werden.

Der berührungsempfindliche Bildschirm kann auch als Sensorbildschirm oder Touchscreen bezeichnet werden. Er kann z.B. ein kapazitiv abfühlender Bildschirm sein. Der berührungsempfindliche Bildschirm ist insbesondere ein bildpunktartig aufgebauter Bildschirm. Der berührungsempfindliche Bildschirm kann ein monochromer (z.B. schwarzweißer) oder ein farbiger Bildschirm sein.

Es ist eine Weiterbildung, dass das gesamte Anzeigefeld als ein berührungsempfindlicher Bildschirm ausgebildet ist. Dies ermöglicht eine besonders großflächige und vielgestaltige berührungsempfindliche Fläche. Es ist eine alternative Weiterbildung, dass ein Teil des Anzeigefelds als mindestens ein berührungsempfindlicher Bildschirm ausgebildet ist und ein restlicher Teil des Anzeigefelds als ein nicht berührungsempfindlicher Bildschirm ausgebildet ist. Dies ermöglicht einen besonders preiswerten Aufbau.

Grundsätzlich ist das Bedienelement ein von dem (restlichen) Haushaltsgerät abnehmbares Bedienelement. Dies ermöglicht eine verbesserte Kindersicherung, verbesserte Reinigbarkeit und durch eine variable Wahl seines Aufsetzpunkts eine verbesserte Bedienbarkeit. Das Bedienelement kann z.B. dazu vorgesehen sein, an einer Bedienblende des Haushaltsgeräts lösbar aufgesetzt zu werden.

Das Bedienelement kann es eine Datenschnittstelle zu dem Haushaltsgerät aufweisen, um Daten mit dem Haushaltsgerät auszutauschen. Das Bedienelement kann ein an dem (restlichen) Haushaltsgerät magnetisch befestigbares Bedienelement sein. Die Datenschnittstelle ist vorteilhafterweise eine drahtlose Datenschnittstelle, beispielsweise eine Nahbereichs-Funkschnittstelle, z.B. in Form eines Bluetooth-Moduls, ZigBee-Moduls usw. Alternativ oder zusätzlich kann das abnehmbare Bedienelement als die Datenschnittstelle mindestens eine Spule zur transformatorischen Datenübertragung aufweisen. Die Spule ermöglicht zudem eine Energieversorgung des abnehmbaren Bedienelements durch Induktion oder Transformation.

Es ist eine Weiterbildung, dass das haptische Bedienelement das Anzeigefeld an seiner frontseitigen, einem Nutzer zugewandten Stirnfläche aufweist. Dies ermöglicht eine besonders gute Sichtbarkeit und große Anzeigefläche. Zusätzlich kann das haptische Bedienelement mindestens ein Anzeigefeld auch an seiner Randfläche aufweisen. Die frontseitige Stirnfläche kann einer ebenen oder leicht gekrümmten Stirnfläche eines knopf- oder zylinderförmigen Bedienelements entsprechen. Das Anzeigefeld kann dann insbesondere kreisförmig oder ringförmig sein.

Es ist eine Weiterbildung, dass praktisch die gesamte berührbare Frontseite des Bedienelements als Anzeigefeld ausgebildet ist, ggf. mit einem schmalen Rand.

Es ist noch eine Ausgestaltung, dass das Bedienelement ein Drehknebel ist, insbesondere ein abnehmbarer Drehknebel. Dies ermöglicht eine intuitiv besonders einfache und zudem ein effektive Bedienung des Haushaltsgeräts. Es ergibt sich der weitere Vorteil, dass mittels eines einzigen Bedienelements zwei bedientechnisch klar getrennte, aber optisch zusammenhängende Bedienarten ausführbar sind, nämlich eine Drehung des Drehknebels an seiner seitlichen Mantelfläche und ein Drücken der frontseitigen Stirnfläche.

Es ist eine weitere Ausgestaltung, dass das Bedienelement eine Datenverarbeitungseinheit zum Datenaustausch mit dem Haushaltsgerät und zum Betreiben seines Bildschirms aufweist. Dadurch kann das Bedienelement auch bei einer geringen Datenübertragungsmenge betrieben werden. Das Haushaltsgerät kann von einem Aufwand zum direkten Betreiben des Bildschirms entlastet werden.

Die Aufgabe wird durch ein Haushaltsgerät, aufweisend mindestens ein haptisches Bedienelement wie oben beschrieben und einen weiteren, gerätefesten Bildschirm gelöst.

Das Haushaltsgerät ergibt die gleichen Vorteile wie das haptische Bedienelement. Das haptische Bedienelement kann als eine Komponente des Haushaltsgeräts angesehen werden.

Das Haushaltsgerät kann ein elektrisch betriebenes Haushaltsgerät sein. Das Haushaltsgerät kann ein Küchengerät sein. Das Haushaltsgerät kann beispielsweise ein Gargerät, ein Wäschebehandlungsgerät oder ein Kältegerät sein. Das Gargerät kann ein Backofen sein oder einen Backofen aufweisen (z.B. ein Herd).

Unter einem gerätefesten Bildschirm wird ein Bildschirm verstanden, der fest an dem Haushaltsgerät angebracht ist. Der gerätefeste Bildschirm kann insbesondere an einer Frontseite, insbesondere an einer frontseitigen Blende, des Haushaltsgeräts angeordnet sein. Der gerätefeste Bildschirm kann ein berührungsempfindlicher Bildschirm oder Touchscreen sein, ist aber nicht darauf beschränkt.

Es ist eine Weiterbildung, dass der gerätefeste Bildschirm zumindest optisch gleichartig zu dem Anzeigefeld des Bedienelements ausgebildet ist. Dies kann insbesondere umfassen, dass das Anzeigefeld des Bedienelements und der gerätefeste Bildschirm eine gleiche Auflösung pro Einheitsfläche und/oder eine gleiche Farbtiefe aufweisen. Dadurch wird ein besonders einheitliches und übersichtliches sowie darstellungstechnisch klares Erscheinungsbild von Anzeigefeld und gerätefestem Bildschirm erreicht.

Es ist eine Weiterbildung, dass das haptische Bedienelement an genau einer vorgegebenen Position an dem Haushaltsgerät anbringbar oder befestigbar ist.

Es ist eine zur besonders vielgestaltig und benutzerfreundlich variierbaren Anordnung vorteilhafte Weiterbildung, dass das haptische Bedienelement an mehreren Positionen an dem Haushaltsgerät anbringbar oder befestigbar ist. So kann ein Nutzer beispielsweise seine bevorzugte Position zur Bedienung des Haushaltsgeräts wählen. Die in beiden Anzeigen (d.h., in dem Anzeigefeld des Bedienelements und in dem gerätefesten Bildschirm) angezeigten Inhalte können an die ausgewählte Position des haptischen Bedienelements angepasst werden. Dies kann auch als eine adaptive Darstellung bezeichnet werden.

Es ist eine Ausgestaltung, dass das Haushaltsgerät eine Steuereinrichtung zum Betreiben des berührungsempfindlichen Anzeigefelds und des gerätefesten Bildschirms aufweist. Dies ermöglicht auf eine besonders einfache Weise eine aufeinander abgestimmte Anzeige des Anzeigefelds und des gerätefesten Bildschirms. Die Steuereinrichtung kann ein Bedienmodul des Haushaltsgeräts sein, das z.B. mit einer zentralen Steuereinrichtung des Haushaltsgeräts gekoppelt ist. Die Steuereinrichtung kann aber auch die zentrale Steuereinrichtung sein.

Es ist noch eine Ausgestaltung, dass die Steuereinrichtung dazu eingerichtet ist, auf dem berührungsempfindlichen Bildschirm des Bedienelements mindestens eine virtuelle Sensorfläche oder Sensortaste als ein Bedienelement des Haushaltsgeräts einzurichten oder zu konfigurieren. Dies ermöglicht eine besonders klar strukturierte, fokussierte und kontextbezogene Gerätebedienung. Es ist eine Weiterbildung, dass der berührungsempfindliche Bildschirm eine einzige Sensortaste aufweist oder bereitstellt. Es ist noch eine Weiterbildung, dass der berührungsempfindliche Bildschirm mehrere Sensortasten aufweist oder bereitstellt.

Es ist eine weitere Ausgestaltung, dass die mindestens eine Sensortaste in zumindest einer Ansicht des Anzeigefelds und des gerätefesten Bildschirms das einzige Bedienelement ist. Dadurch kann eine klare Bedienstruktur bereitgestellt werden, die es dem Nutzer ermöglicht, das Haushaltsgerät - zumindest in der dargestellten Ansicht - ausschließlich über das haptische Bedienelement zu bedienen. Unter einer Ansicht kann insbesondere eine zu einem bestimmten Punkt in einer Menüstruktur gehörige Ansicht des Anzeigefelds und des gerätefesten Bildschirms verstanden werden ("Menüansicht").

Insbesondere falls der gerätefeste Bildschirm ein berührungsempfindlicher Bildschirm ist, kann das Haushaltsgerät in einer alternativen Weiterbildung zusätzlich darüber bedient werden.

Es ist die erfindungsgemäße Ausgestaltung, dass das Haushaltsgerät, insbesondere dessen Steuereinrichtung, dazu eingerichtet ist, ein grafisches Erscheinungsbild auf dem Anzeigefeld des Bedienelements auf ein grafisches Erscheinungsbild des gerätefesten Bildschirms abzustimmen. So wird eine besonders übersichtliche, einheitliche Darstellung über beide Anzeigen hinweg erreicht. Dies wiederum ermöglicht eine besonders klare und hochwertig wirkende Darstellung und erleichtert eine Bedienbarkeit. Unter der Abstimmung kann z.B. eine funktionale, inhaltliche und/oder grafische Abstimmung verstanden werden, beispielsweise durch sich ergänzende Funktionen und/oder Inhalte sowie durch ein aufeinander abgestimmtes grafisches Design.

Es ist ferner die erfindungsgemäße Ausgestaltung, dass das haptische Bedienelement so an dem Haushaltsgerät anbringbar ist, dass es den gerätefesten Bildschirm zumindest teilweise überdeckt. Dies kann umfassen, dass das haptische Bedienelement den gerätefesten Bildschirm mit nur einem Teil überdeckt. In einer anderen Weiterbildung kann das haptische Bedienelement ganz auf dem gerätefesten Bildschirm positioniert sein.

Es ist auch die erfindungsgemäße Ausgestaltung, dass das Haushaltsgerät, insbesondere dessen Steuereinrichtung, dazu eingerichtet ist, ein grafisches Erscheinungsbild auf dem Anzeigefeld des Bedienelements auf ein grafisches Erscheinungsbild des durch das Bedienelement abgedeckten Teilbereichs des gerätefesten Bildschirms abzustimmen. Dadurch wird der Vorteil erreicht, dass das Anzeigefeld des haptischen Bedienelements von dem Nutzer als ein mit dem gerätefesten Bildschirm integral verbundener Teil wahrgenommen wird.

Es ist außerdem eine Ausgestaltung, dass das Haushaltsgerät, insbesondere dessen Steuereinrichtung, dazu eingerichtet ist, auf dem Anzeigefeld des Bedienelements den durch das Bedienelement abgedeckten Teilbereich des gerätefesten Bildschirms darzustellen. Dadurch lässt sich der Eindruck einer einzigen, zusammenhängenden Darstellung auf beiden Anzeigen hervorrufen. Insbesondere kann so vermieden werden, dass das Bedienelement Teilbereiche der Darstellung auf dem gerätefesten Bildschirm abdeckt und folglich für einen Nutzer unzugänglich macht.

Es ist eine Weiterbildung, dass das Haushaltsgerät, insbesondere dessen Steuereinrichtung, dazu eingerichtet ist, den abgedeckten Teilbereich des gerätefesten Bildschirms auf dem Anzeigefeld des Bedienelements in einem Lupeneffekt darzustellen. Dies ermöglicht eine verbesserte Bedienerführung und eine besonders hochwertige Anmutung.

Es ist zudem eine Ausgestaltung, dass das Haushaltsgerät, insbesondere dessen Steuereinrichtung, dazu eingerichtet ist, auf dem Anzeigefeld des Bedienelements mindestens eine grafische Animation ablaufen zu lassen. Dies ermöglicht es, eine Aufmerksamkeit eines Nutzers auf das Anzeigefeld des Bedienelements zu lenken. Beispielsweise kann mittels einer sog. "Flip Coin"-Animation optisch hochwertig zwischen zwei durch den berührungsempfindlichen Bildschirm des Bedienelements auslösbare Funktionen umgeschaltet werden. Es ist eine Weiterbildung, dass das Haushaltsgerät, insbesondere dessen Steuereinrichtung, dazu eingerichtet ist, die grafische Animation als Reaktion auf eine Betätigung einer Sensortaste des Bedienelements ablaufen zu lassen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden schematischen Beschreibung eines Ausführungsbeispiels, das im Zusammenhang mit den Zeichnungen näher erläutert wird.
- Fig.1: zeigt eine Frontansicht eines Haushaltsgeräts mit einem gerätefesten Bildschirm und einem haptischen Bedienelement;
- Fig.2: zeigt eine Frontansicht des gerätefesten Bildschirms und des haptischen Bedienelements in einer ersten Ansicht; und
- Fig.3: zeigt eine Frontansicht des gerätefesten Bildschirms und des haptischen Bedienelements in einer zweiten Ansicht.

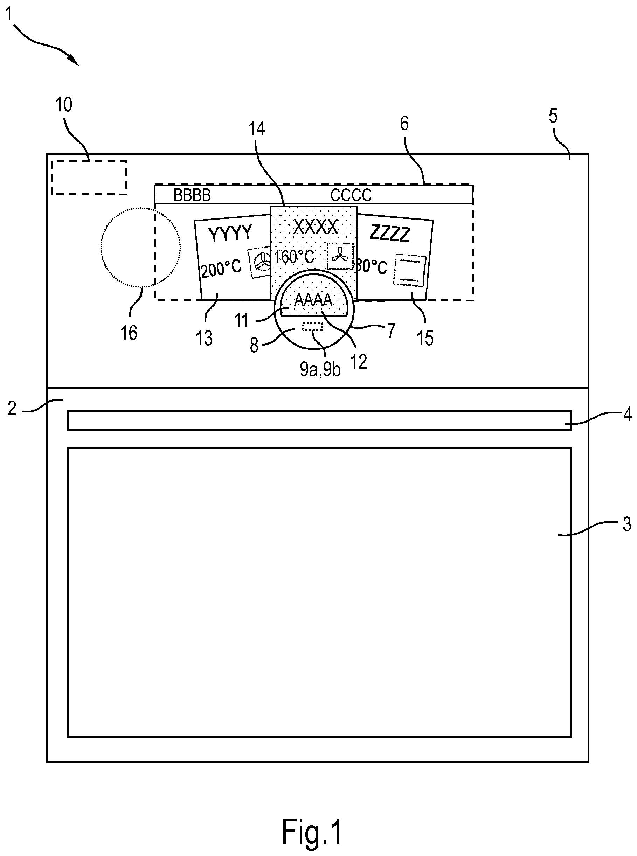

**Fig.1** zeigt ein Haushaltsgerät in Form eines Backofens 1. Der Backofen 1 weist eine Backofentür 2 mit einem Sichtfenster 3 und einem Türgriff 4 auf. Oberhalb der Backofentür 2 befindet sich eine Bedienblende 5, in der ein gerätefester, farbiger Bildschirm 6 eingelassen ist. Der Bildschirm 6 kann ein Touchscreen sein. In der Bedienblende 5 können weitere Betätigungselemente wie Tasten, insbesondere Sensortasten, usw. vorhanden sein, beispielsweise ein Ein/Aus-Schalter (o. Abb.). Die Bedienblende 5 kann alternativ in die Backofentür 2 integriert sein.

Der Backofen 1 weist ferner ein frontseitig anbringbares haptisches Bedienelement in Form eines magnetisch befestigbaren Drehknebels 7 auf. Der Drehknebel 7 weist eine knopf- oder zylinderförmige Grundform auf, von der eine rückseitige Stirnfläche als Auflagefläche dient und eine frontseitige Stirnfläche für einen Nutzer sichtbar ist. Eine seitliche Mantelfläche dient als Grifffläche, um den Drehknebel 7 zu drehen. Der Drehknebel 7 überdeckt mit einem Teil den Bildschirm 6 und steht mit dem anderen Teil nach unten über den Bildschirm 6 hinaus.

Der Drehknebel 7 weist an seiner frontseitigen Stirnfläche einen berührungsempfindlichen Bildschirm oder Touchscreen 8 auf. Der Touchscreen 8 nimmt praktisch die gesamte frontseitige Stirnfläche ein und entspricht somit dem gesamten sichtbaren Anzeigefeld.

Der Drehknebel 7 kann eine drahtlos Daten übertragende Datenschnittstelle 9a zu dem Backofen 1 aufweisen. Die Datenschnittstelle 9a kann eine Funkschnittstelle, eine induktiv Daten übertragende Schnittstelle usw. sein. Der Drehknebel 7 kann ferner eine Datenverarbeitungseinheit 9b (z.B. einen Mikrocontroller, ASIC, FPGA oder eine andere Elektronik) zum Datenaustausch mit dem Backofen 1 über die Datenschnittstelle 9a und zum Betreiben des Touchscreens 8 aufweisen.

Der Backofen 1 weist zudem eine Steuereinrichtung 10 zum Betreiben des Touchscreens 8 und des Bildschirms 6 auf. Die Steuereinrichtung 10 kann eine zentrale Steuerung des Backofens 1 sein.

Der Backofen 1 bzw. dessen Steuereinrichtung 10 ist dazu eingerichtet, auf dem Touchscreen 8 mindestens eine - hier annähernd halbkreisförmige - Sensorfläche oder Sensortaste 11 als ein Bedienelement des Backofens 1 virtuell einzurichten. Die restliche Fläche des Touchscreens 8 kann so eingerichtet sein, dass seine Berührung keine Aktion auslöst, sie also nicht als Sensortaste eingerichtet ist. Alternativ kann die gesamte Fläche des Touchscreens 8 als Sensortaste eingerichtet oder konfiguriert sein.

Die grafische Ausgestaltung des Touchscreens 8 ist grundsätzlich beliebig. So kann die der Sensortaste 11 zugeordnete Fläche eine andere Farbe aufweisen als die restliche Fläche des Touchscreens 8. Auch kann die der Sensortaste 11 zugeordnete Fläche eine Beschriftung 12 aufweisen, z.B. gemäß "AAAA" = "Start", "Set", "Pause", "Stopp" usw. Grundsätzlich können an dem Touchscreen 8 mehrere Sensortasten eingerichtet werden (o. Abb.). In der hier gezeigten Menüansicht ist die Sensortaste 11 das einzige auf dem Bildschirm 6 und dem Touchscreen 8 ausgebildete Betätigungselement.

In der gezeigten Menüansicht ist die auf dem Touchscreen 8 angezeigte Grafik auf die auf dem Bildschirm 8 angezeigte Grafik abgestimmt. In dem Bildschirm 6 werden hier beispielhaft mehrere Karten 13, 14, 15 nachgebildete Bereiche angezeigt, wobei die Karten 13 bis 15 nach Art eines Fächers nebeneinander angeordnet sind. Dabei steht eine mittlere Karte 14 bildlich hervor, während die dazu benachbarten Karten 13, 15 bildlich hinter der mittleren Karte 14 angeordnet sind und von dieser wie teilweise verdeckt angezeigt werden. Nur die der mittleren Karte 14 zugeordnete Information ist vollständig sichtbar. Beispielsweise kann jede der Karten 13 bis 15 Parameter für eine bestimmte Garbetriebsart oder Garfunktion anzeigen, z.B. "XXXX" = "Circotherm", "YYYY" = "Circotherm ECO" und "ZZZZ" = "Ober- und Unterhitze". Ferner kann jede der Karten eine Soll-Garraumtemperatur (z.B. 160 °C, 180°C oder 200 °C) und symbolisch zugehörige Heizart (z.B. Heißluft, Umluft, Unter- und Oberhitze usw.) anzeigen. Die Hintergrundfarbe der mittleren Karte 14 (z.B. rot) ist eine andere als die Hintergrundfarbe der Karten 13 und 15 (z.B. weiß).

Zur Abstimmung mit dem Bildschirm 6 entspricht die Hintergrundfarbe der Sensortaste 11 der Hintergrundfarbe der Karte 14. Dadurch wird grafisch die funktionale Zugehörigkeit der Sensortaste 11 zu der mittleren Karte 14 hervorgehoben, nämlich dass die durch die Beschriftung 12 der Sensortaste 11 beschriebene Funktion auf die durch die Karte 14 angezeigte Garbetriebsart oder Garfunktion wirkt. Drückt ein Nutzer beispielsweise auf die Sensortaste 11, wenn diese die Beschriftung 12 "Start" aufweist, wird die durch die mittlere Karte 14 beschriebene Garfunktion "Circotherm" mit der zuvor eingestellten Garraumtemperatur von 160°C und der Aktivierung des Umluftlüfters in Gang gesetzt. Parameter können beispielsweise durch Drehen des Drehknebels 7 unter der Funktion "Set" variiert werden. Dies ergibt den Vorteil, dass der Nutzer sowohl eine Auswahlfunktion durch Drehen des Drehknebels 7 als auch die häufig folgende Tastenfunktion an dem Drehknebel 7 durchführen kann. Der Nutzer braucht also seine Aufmerksamkeit nicht von dem Drehknebel 7 wegzulenken, um eine Taste zu suchen.

Die farblich auf die Karte 14 abgestimmte Sensortaste 11 erweckt bei einem Nutzer den Eindruck, dass die Sensortaste 11 zumindest annähernd denjenigen Teilbereich des Bildschirms 6 zeigt, der durch den Drehknebel 7 abgedeckt wird. Dabei steht die Sensortaste 11 optisch nach unten leicht über die untere Begrenzung des Bildschirms 6 heraus, wodurch ein Eindruck ähnlich einer Verwendung des Drehknebels 7 als einer Lupe ("Lupeneffekt") erzeugt wird.

Oberhalb der Karten 13 bis 15 kann der Bildschirm 6 weitere Informationen anzeigen, z.B. "BBBB" = "Backen", "CCCC" = "Garbetriebsarten" und/oder weitere Symbole (o. Abb.).

Der Drehknebel 7 kann in einer Weiterbildung außer an dem unteren Rand des Bildschirms 6 auch z.B. an einem linken, rechten oder oberen Seitenrand des Bildschirms 6 magnetisch haften aufgesetzt werden, wie durch den Ring 16 angedeutet. Der Backofen 1 erkennt automatisch, an welcher Position der Drehknebel 7 aufgesetzt worden ist und konfiguriert den grafischen Aufbau des Bildschirms 6 und des Touchscreens 8 entsprechend um. Beispielweise kann bei einer Anbringung des Drehknebels 7 an einem Seitenrand des Bildschirms 6 das Sensorfeld 11 um 90° im Uhrzeigersinn gedreht dargestellt werden usw.

Es ist auch möglich, auf dem Touchscreen 8 mindestens eine grafische Animation ablaufen zu lassen, z.B. eine Flip-Coin-Animation. Bei der Flip-Coin-Animation kann das Sensorfeld in einer hier nicht gezeigten Ansicht eine kreisrunde Form aufweisen und zum Beispiel mit der Aufschrift "Start" versehen sein, beispielsweise zum Starten eines Garprogramms oder einer Garbetriebsart. Betätigt der Nutzer die Sensortaste, zieht sie sich in vertikaler Richtung bis zu einem Strich zusammen und dehnt sich dann wieder auf die kreisrunde Form aus. Nach dem Wiederausdehnen ist jedoch eine andere Aufschrift vorhanden, z.B. "Pause". Diese Animation bildet ein Drehen einer Scheibe oder Münze nach, die auf ihren beiden Seiten eine unterschiedliche Aufschrift trägt und somit auch unterschiedliche Funktionen zur Aktivierung freigibt.

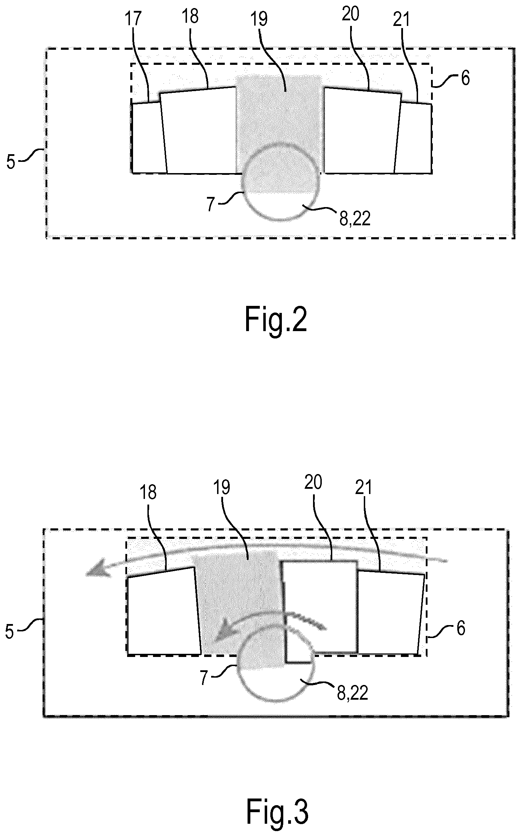

**Fig.2** zeigt eine Frontansicht des gerätefesten Bildschirms 6 und des Drehknebels 7 in einer ersten Ansicht. Diese erste Ansicht ist ähnlich zu der in Fig.1 gezeigten Ansicht und zeigt in dem gerätefesten Bildschirm 6 fünf Karten 17 bis 21 in fächerförmiger Anordnung. Die mittlere Karte 19 befindet sich bildlich im Vordergrund. Der Touchscreen 8 stellt einen unteren Bereich der mittleren Karte 19 in Lupenansicht dar. Durch Drücken der an dem Touchscreen 8 eingerichteten Sensortaste - hier eine den ganzen Touchscreen 8 einnehmenden Sensortaste 22 - kann analog zu Fig.1 die der mittleren Karte 19 unterlegte Funktion(en) ausgelöst werden.

Fig.3 zeigt eine Frontansicht des gerätefesten Bildschirms 6 und des Drehknebels 7 in einer zweiten Ansicht. In dieser zweiten Ansicht werden durch Drehen des Drehknebels 7 (wie durch den kurzen gekrümmten Pfeil angedeutet) die Karten 17 bis 21 analog der Reihe nach durch den Bildschirm 6 gedreht (wie durch den kurzen gekrümmten Pfeil angedeutet). Mit der bildlichen Drehung der Karten 17 bis 21 passt sich auch die Darstellung in dem Touchscreen 8 an.

Auf eine Blende kann verzichtet werden und der gerätefeste Bildschirm kann in der Tür angeordnet sein.

Allgemein kann unter "ein", "eine" usw. eine Einzahl oder eine Mehrzahl verstanden werden, insbesondere im Sinne von "mindestens ein" oder "ein oder mehrere" usw., solange dies nicht explizit ausgeschlossen ist, z.B. durch den Ausdruck "genau ein" usw.

Auch kann eine Zahlenangabe genau die angegebene Zahl als auch einen üblichen Toleranzbereich umfassen, solange dies nicht explizit ausgeschlossen ist.

### Bezugszeichenliste

- 1: Backofen
- 2: Backofentür
- 3: Sichtfenster
- 4: Türgriff
- 5: Blende
- 6: Bildschirm
- 7: Drehknebel
- 8: Touchscreen
- 9a: Datenschnittstelle
- 9b: Datenverarbeitungseinheit
- 10: Steuereinrichtung
- 11: Sensortaste
- 12: Beschriftung
- 13: Karte
- 14: Karte
- 15: Karte
- 16: Ring
- 17: Karte
- 18: Karte
- 19: Karte
- 20: Karte
- 21: Karte
- 22: Sensortaste

## Patentansprüche

1. Haushaltsgerät, aufweisend mindestens ein haptisches Bedienelement (7) und einen weiteren, gerätefesten Bildschirm (6),
wobei das Haushaltsgerät (1) eine Steuereinrichtung (10) zum Betreiben des Anzeigefelds (8) des Bedienelements (7) und des gerätefesten Bildschirms (6) aufweist, wobei das haptische Bedienelement (7) so an dem Haushaltsgerät (1) anbringbar ist, dass es den gerätefesten Bildschirm (6) zumindest teilweise überdeckt, **dadurch gekennzeichnet, dass**
das haptische Bedienelement ein zumindest teilweise als ein berührungsempfindlicher Bildschirm ausgebildetes Anzeigefeld (8) aufweist und
dass die Steuereinrichtung (10) dazu eingerichtet ist, ein grafisches Erscheinungsbild auf dem Anzeigefeld (8) des Bedienelements (7) auf ein grafisches Erscheinungsbild eines durch das Bedienelement (7) abgedeckten Teilbereichs des gerätefesten Bildschirms (6) abzustimmen.

2. Haushaltsgerät (1) nach Anspruch 1, **dadurch gekennzeichnet, dass** die Steuereinrichtung dazu eingerichtet ist, auf dem berührungsempfindlichen Bildschirm (8) des Bedienelements (7) mindestens eine Sensortaste (11, 22) als ein Bedienelement (7) des Haushaltsgeräts (1) einzurichten.

3. Haushaltsgerät (1) nach Anspruch 2, **dadurch gekennzeichnet, dass** die mindestens eine Sensortaste (11, 22) in zumindest einer Ansicht des Anzeigefelds (8) und des gerätefesten Bildschirms (6) das einzige Bedienelement (7) ist.

4. Haushaltsgerät (1) nach einem der Ansprüche 1 bis 3, **dadurch gekennzeichnet, dass** die Steuereinrichtung (10) dazu eingerichtet ist, ein grafisches Erscheinungsbild auf dem Anzeigefeld (8) des Bedienelements (7) auf ein grafisches Erscheinungsbild des gerätefesten Bildschirms (6) abzustimmen.

5. Haushaltsgerät (1) nach Anspruch 1, **dadurch gekennzeichnet, dass** die Steuereinrichtung (10) dazu eingerichtet ist, auf dem Anzeigefeld (8) des Bedienelements den durch das Bedienelement (7) abgedeckten Teilbereich des gerätefesten Bildschirms (6) darzustellen, insbesondere in einem Lupeneffekt.

6. Haushaltsgerät (1) nach einem der Ansprüche 1 bis 5, **dadurch gekennzeichnet, dass** die Steuereinrichtung (10) dazu eingerichtet ist, auf dem Anzeigefeld (8) des Bedienelements (7) mindestens eine grafische Animation ablaufen zu lassen.

## Claims

1. Household appliance, having at least one haptic operating element (7) and a further screen (6) fixed relative to the appliance,
wherein the household appliance (1) has a control facility (10) for operating the display field (8) of the operating element (7) and the screen (6) fixed relative to the appliance, wherein the haptic operating element (7) can be positioned on the household appliance (1) in such a manner that it at least partially covers the screen (6) fixed relative to the appliance,
**characterised in that**
the haptic operating element has a display field (8) configured at least partially as a touch-sensitive screen and
the control facility (10) is designed to coordinate a graphic appearance on the display field (8) of the operating element (7) with a graphic appearance of a sub-region of the screen (6) fixed relative to the appliance, which is covered by the operating element (7).

2. Household appliance (1) according to claim 1, **characterised in that** the control facility is designed to configure at least one sensor key (11, 22) as an operating element (7) of the household appliance (1) on the touch-sensitive screen (8) of the operating element (7).

3. Household appliance (1) according to claim 2, **characterised in that** the at least one sensor key (11, 22) is the only operating element (7) in at least one view of the display field (8) and the screen (6) fixed relative to the appliance.

4. Household appliance (1) according to one of claims 1 to 3, **characterised in that** the control facility (10) is designed to coordinate a graphic appearance on the display field (8) of the operating element (7) with a graphic appearance of the screen (6) fixed relative to the appliance.

5. Household appliance (1) according to claim 1, **characterised in that** the control facility (10) is designed to display the sub-region of the screen (6) fixed relative to the appliance, which is covered by the operating element (7), on the display field (8) of the operating element, in particular with a magnifying effect.

6. Household appliance (1) according to one of claims 1 to 5, **characterised in that** the control facility (10) is designed to allow at least one graphic animation to run on the display field (8) of the operating element (7).

## Revendications

1. Appareil ménager présentant au moins un élément de commande (7) haptique et un écran (6) supplémentaire fixé sur l'appareil,
dans lequel l'appareil ménager (1) présente un dispositif de commande (10) pour le fonctionnement du champ d'affichage (8) de l'élément de commande (7) et de l'écran (6) fixé sur l'appareil,
dans lequel l'élément de commande (7) haptique peut être placé sur l'appareil ménager (1) de manière à recouvrir au moins en partie l'écran (6) fixé sur l'appareil,
**caractérisé en ce que**
l'élément de commande haptique présente un champ d'affichage (8) réalisé au moins en partie en tant qu'un écran tactile, et
**en ce que** le dispositif de commande (10) est configuré pour harmoniser une image graphique sur le champ d'affichage (8) de l'élément de commande (7) à une image graphique d'une zone partielle de l'écran (6) fixé sur l'appareil, recouverte par l'élément de commande (7).

2. Appareil ménager (1) selon la revendication 1, **caractérisé en ce que** le dispositif de commande est configuré pour créer sur l'écran (8) tactile de l'élément de commande (7) au moins une touche (11, 22) à contact sensitif en tant qu'un élément de commande (7) de l'appareil ménager (1).

3. Appareil ménager (1) selon la revendication 2, **caractérisé en ce que** l'au moins une touche (11, 22) à contact sensitif est le seul élément de commande (7) dans au moins une vue du champ d'affichage (8) et de l'écran (6) fixé sur l'appareil.

4. Appareil ménager (1) selon l'une quelconque des revendications 1 à 3, **caractérisé en ce que** le dispositif de commande (10) est configuré pour harmoniser une image graphique sur le champ d'affichage (8) de l'élément de commande (7) à une image graphique de l'écran (6) fixé sur l'appareil.

5. Appareil ménager (1) selon la revendication 1, **caractérisé en ce que** le dispositif de commande (10) est configuré pour représenter sur le champ d'affichage (8) de l'élément de commande, notamment dans un effet de loupe, la zone partielle de l'écran (6) fixé sur l'appareil, recouverte par l'élément de commande (7).

6. Appareil ménager (1) selon l'une quelconque des revendications 1 à 5, **caractérisé en ce que** le dispositif de commande (10) est configuré pour laisser se dérouler au moins une animation graphique sur le champ d'affichage (8) de l'élément de commande (7).
